# EUROPEAN PATENT APPLICATION

(11) **EP 3 132 847 A1**
(43) Date of publication of application: **22.02.2017**
(21) Application number: 15779692.1
(22) Date of filing: 13.04.2015
(51) Int. Cl.: B01J 19/00, B81B 1/00, G01M 3/16, G01N 27/04

(54) **CHEMICAL SYNTHESIS APPARATUS, AND METHOD FOR MANUFACTURING CHEMICAL SYNTHESIS APPARATUS**

(30) Priority: 15.04.2014 JP 2014083672
(71) Applicant: Seiko Epson Corporation, Tokyo 160-8801 (JP)
(72) Inventor: SERA, Hiroshi, Suwa-shi Nagano 392-8502 (JP)
(74) Representative: Hoffmann Eitle
(86) International application number: PCT/JP2015/002059
(87) International publication number: WO 2015/159532

(57) **Abstract**

A chemical synthesis device which can detect leakage of a fluid out of a channel and a method of manufacturing the chemical synthesis device are to be provided.

An aspect of a chemical synthesis device according to the invention includes a substrate in which a channel for chemically synthesizing a plurality of fluids with each other is formed, and a wiring portion that is embedded in the substrate, in which an electric resistance value of the wiring portion changes due to the wiring portion coming into contact with the fluids.

## Description

### Technical Field

The present invention relates to a chemical synthesis device and a method of manufacturing the chemical synthesis device.

### Background Art

In the related art, for example, there is a microreactor as a device which performs chemical reaction in a space whose one side is 1 mm or less. As a simple device, there is a device in which fine grooves are formed in a T shape in a plate, and the plate is covered with a lid and connected to a tube. PTL 1 proposes a microreactor in which a microfluid flows through a channel formed inside a base body, and thus various biochemical reactions and the like are performed.

### Citation List

### Patent Literature

PTL 1: JP-A-2012-192300

### Summary of Invention

### Technical Problem

However, in the above microreactor, there is a case where a fluid may leak out of the base body due to deterioration or the like caused by corrosion. If the fluid leaks out of the base body, there is a concern over the occurrence of a problem that a quality of a generated compound changes because a ratio between chemically synthesized fluids changes, or a problem that a yield of a generated compound is reduced. In order to cope with the problems, there is a need for detecting leakage of a fluid out of a channel early.

### Solution to Problem

The present invention has been made in light of the problems, and can provide a chemical synthesis device which can detect leakage of a fluid out of a channel, and a method of manufacturing the chemical synthesis device.

A chemical synthesis device according to the invention includes a substrate in which a channel for chemically synthesizing a plurality of fluids with each other is formed; and a wiring portion that is embedded in the substrate, in which an electric resistance value of the wiring portion changes due to the wiring portion coming into contact with the fluids.

According to this configuration, the wiring portion whose electric resistance value changes due to contact with a fluid is embedded in the substrate in which the channel is formed. Thus, if the fluid leaks out of the channel into the substrate, the fluid comes into contact with the wiring portion. Therefore, according to the chemical synthesis device of the aspect of the invention, it is possible to detect leakage of a fluid out of the channel by detecting a change in an electric resistance value of the wiring portion.

In the chemical synthesis device, it is preferable that the wiring portion is provided to surround the periphery of the channel in a sectional view.

According to this configuration, it is possible to provide a structure in which, when a fluid leaks out of the channel, the fluid easily comes into contact with the wiring portion.

In the chemical synthesis device, it is preferable that the wiring portion is provided in plurality, the plurality of wiring portions are arranged in a flow direction of the channel, and a length direction of each of the wiring portions intersects the flow direction of the channel.

According to this configuration, it is possible to provide a structure in which a position where leakage of a fluid occurs in the channel is specified on the basis of a position of the wiring portion in which a change in an electric resistance value thereof is detected.

In the chemical synthesis device, it is preferable that the length direction of the wiring portion is orthogonal to the flow direction of the channel.

According to this configuration, it is possible to provide a structure in which a position where leakage of a fluid occurs in the channel is more accurately specified.

In the chemical synthesis device, it is preferable that a projection is formed on an inner wall surface of the channel.

According to this configuration, it is possible to provide a structure in which heat is easily transmitted to a fluid flowing through the channel when the channel is heated.

In the chemical synthesis device, it is preferable that the wiring portion is provided at a position corresponding to the projection.

According to this configuration, it is possible to easily manufacture the chemical synthesis device.

In the chemical synthesis device, it is preferable that a recess is formed on an inner wall surface of the channel, and the wiring portion is provided at a position corresponding to the recess.

According to this configuration, it is possible to provide a structure in which a fluid which has leaked out of the channel easily comes into contact with the wiring portion.

It is preferable that the chemical synthesis device further includes a heating portion that heats the channel.

According to this configuration, for example, in a case where chemical reaction in the channel is endothermic reaction, it is possible to provide a structure in which the reaction can be promoted.

In the chemical synthesis device, it is preferable that the wiring portion functions as the heating portion.

According to this configuration, a structure is simple since the wiring portion can be used as the heating portion.

In the chemical synthesis device, it is preferable that the wiring portion is heated through conduction.

According to this configuration, a heating amount can be controlled by controlling a current flowing through the wiring portion, and thus it is possible to easily control the temperature of a fluid.

It is preferable that the chemical synthesis device further includes an auxiliary wiring portion whose electric resistance value changes due to contact with the fluids, and the auxiliary wiring portion is embedded at a position further separated from the channel than a position where the wiring portion is provided.

According to this configuration, it is possible to provide a structure in which leakage of a fluid out of the channel is more easily detected.

In the chemical synthesis device, it is preferable that the auxiliary wiring portion is provided to surround the periphery of the channel in a sectional view in the entire flow direction of the channel.

According to this configuration, it is possible to provide a structure in which leakage of a fluid out of the channel is more easily detected.

In the chemical synthesis device, it is preferable that a portion located further toward the channel side than the wiring portion in the substrate has lower corrosion resistance to the fluids than other portions in the substrate.

According to this configuration, it is possible to provide a structure in which, when a fluid leaks out of the channel, the fluid more easily comes into contact with the wiring portion.

It is preferable that the chemical synthesis device further includes a detector that detects a change in an electric resistance value of the wiring portion.

According to this configuration, it is possible to provide a structure in which the detector can detect leakage of a fluid.

In the chemical synthesis device according to the aspect, it is preferable that the detector is provided on the substrate.

According to this configuration, it is possible to miniaturize the chemical synthesis device.

In the chemical synthesis device, it is preferable that the wiring portion is provided in plurality, and the detector detects a change in an electric resistance value of the wiring portion by comparing electric resistance values of at least two wiring portions with each other.

According to this configuration, for example, a bridge circuit is formed by using at least two wiring portions, and thus it is possible to easily detect leakage of a fluid even in a case where a change in an electric resistance value of the wiring portion is slight.

A method of manufacturing a chemical synthesis device according to the invention is a method of manufacturing a chemical synthesis device that includes a substrate in which a channel for chemically synthesizing a plurality of fluids with each other is formed, the method including a step of forming a wiring portion which is embedded in the substrate and whose electric resistance value changes due to contact with the fluids.

According to the method, it is possible to manufacture the chemical synthesis device which can detect leakage of a fluid out of the channel.

### Brief Description of Drawings

[Fig. 1] Fig. 1 is a plan view illustrating a chemical synthesis device of a first embodiment.
[Fig. 2] Fig. 2 is a diagram illustrating the chemical synthesis device of the first embodiment, and is a sectional view taken along the line II-II in Fig. 1.
[Fig. 3] Fig. 3 is a diagram illustrating the chemical synthesis device of the first embodiment, and is a sectional view taken along the line III-III in Fig. 1.
[Fig. 4] Fig. 4 is a partial enlarged sectional view illustrating a synthesis section of the first embodiment.
[Fig. 5] Fig. 5 is a partial sectional perspective view illustrating a synthesis channel portion of the first embodiment.
[Fig. 6] Fig. 6 is a flowchart illustrating procedures of forming the synthesis section of the first embodiment.
[Fig. 7] Figs. 7A to 7D are sectional views illustrating procedures of forming the synthesis section of the first embodiment.
[Fig. 8] Figs. 8A to 8C are sectional views illustrating procedures of forming the synthesis section of the first embodiment.
[Fig. 9] Fig. 9 is a sectional view illustrating a case where the synthesis channel portion of the first embodiment is damaged.
[Fig. 10] Fig. 10 is a partial enlarged sectional view illustrating another example of the synthesis section of the first embodiment.
[Fig. 11] Fig. 11 is a partial enlarged sectional view illustrating a synthesis section of a second embodiment.
[Fig. 12] Fig. 12 is a partial enlarged sectional view illustrating a synthesis section of a third embodiment.
[Fig. 13] Fig. 13 is a plan view illustrating a chemical synthesis device of a fourth embodiment.

### Description of Embodiments

Hereinafter, with reference to the drawings, a chemical synthesis device according to embodiments of the invention will be described. The scope of the invention is not limited to the following embodiments, and can be arbitrarily changed within the scope of the technical spirit of the invention. In the following drawings, for better understanding of each constituent element, a scale, the number, and the like thereof in each structure may be different from a scale, the number, and the like thereof in an actual structure.

In the present specification, an "upstream side" and a "downstream side" are related to a flow in a channel.

In the present specification, a "flow direction" indicates a principal direction of a flow in a channel.

### <First Embodiment>

### [Chemical Synthesis Device]

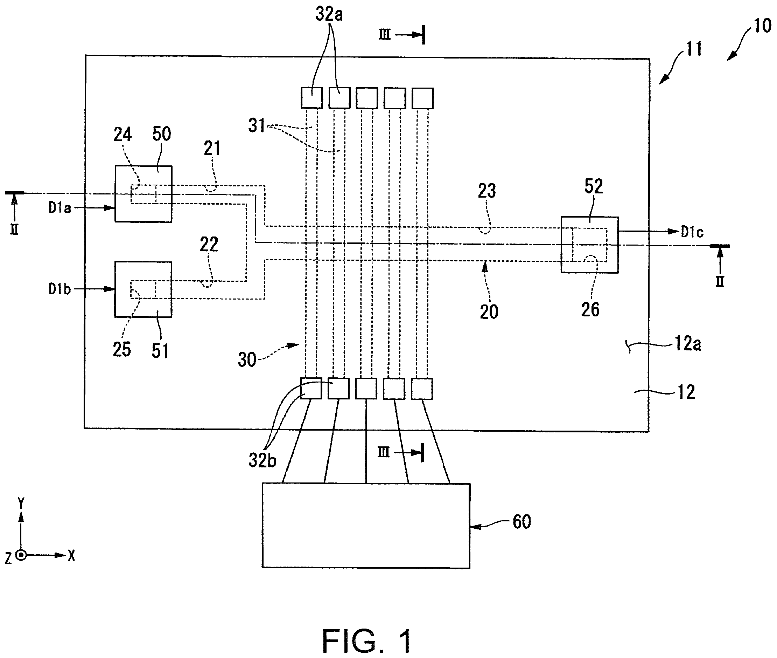

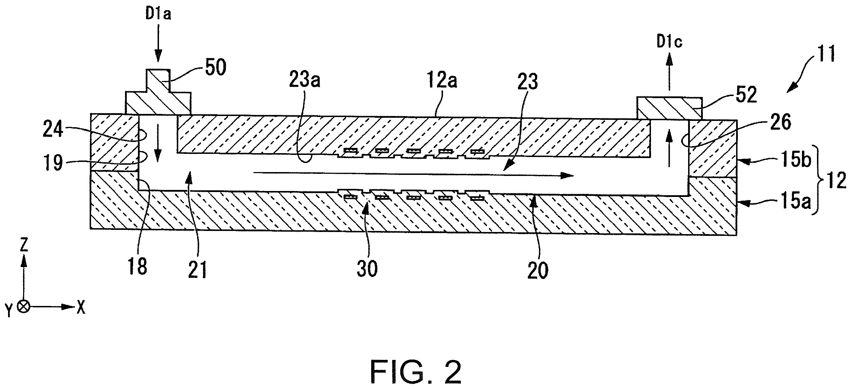

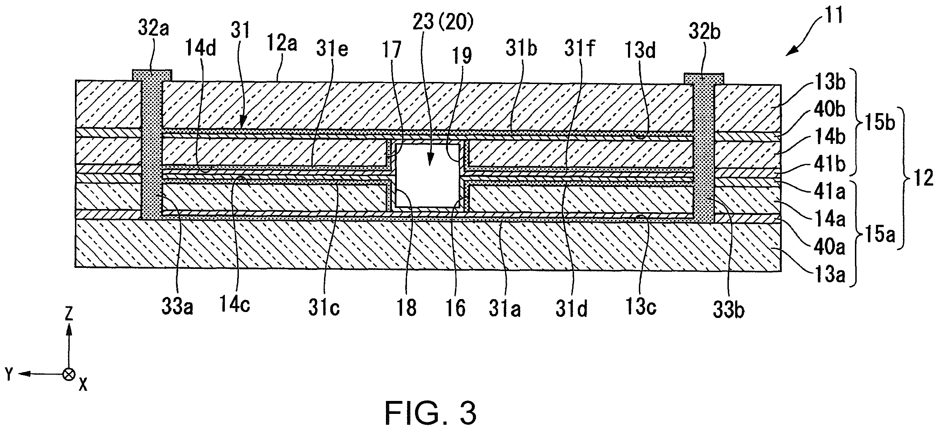

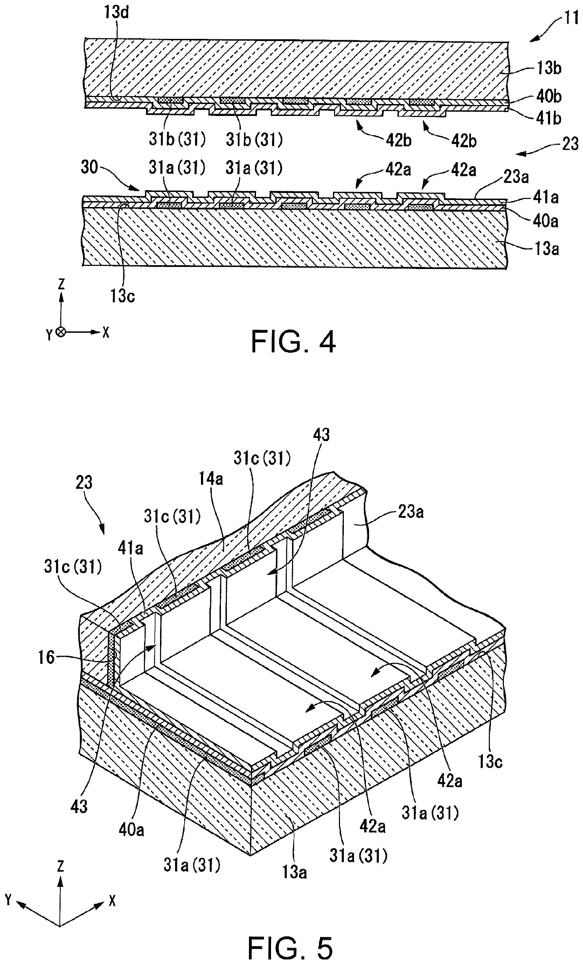

Figs. 1 to 3 are diagrams illustrating a chemical synthesis device 10 of the present embodiment. Fig. 1 is a plan view. Fig. 2 is a sectional view taken along the line II-II in Fig. 1. Fig. 3 is a sectional view taken along the line III-III in Fig. 1. Fig. 4 is a partial enlarged sectional view illustrating a synthesis section 11 of the present embodiment. Fig. 5 is a partial sectional perspective view illustrating a synthesis channel portion 23 of the present embodiment. Fig. 2 illustrates a substrate 12 and a wiring portion group 30 in a simplified manner.

In the following description, an XYZ coordinate system is set, and positional relationships among respective constituent elements will be described with reference to the XYZ coordinate system. In this case, a normal direction of the substrate 12 (refer to Fig. 1) is set as a Z axis direction, a width direction of the substrate 12 is set as a Y axis direction, and a length direction of the substrate 12 is set as an X axis direction.

The chemical synthesis device 10 of the present embodiment includes the synthesis section 11 and a detector 60 as illustrated in Fig. 1.

The synthesis section 11 includes the substrate 12 and the wiring portion group 30.

### (Substrate)

A shape of the substrate 12 is a rectangular shape in a plan view (in an XY-plane view) in the present embodiment. As illustrated in Fig. 2, a channel 20 is formed inside the substrate 12. In other words, the substrate 12 forms an inner wall surface of the channel 20. The substrate 12 has a first laminated substrate 15a and a second laminated substrate 15b.

The first laminated substrate 15a is formed of a support substrate 13a, a first protection film 40a, a sidewall layer 14a, and a second protection film 41a which are laminated in this order, as illustrated in Fig. 3.

A groove 18 is formed on a surface of the first laminated substrate 15a on the second laminated substrate 15b side (+Z side).

The support substrate 13a is, for example, a glass substrate. A first wiring portion 31a which will be described later is formed on an upper surface 13c of the support substrate 13a on the channel 20 side (+Z side). The first protection film 40a is formed on the upper surface 13c of the support substrate 13a so as to cover the first wiring portion 31a.

The first protection film 40a is made of an insulating material. As a material forming the first protection film 40a, for example, an inorganic substance such as SiO₂ or SiN, or a photosensitive resin may be selected. A material forming the first protection film 40a may be determined depending on a fluid flowing through the channel 20. As an example, in a case where a fluid flowing through the channel 20 is a hydrofluoric acid, the photosensitive resin having high corrosion resistance to the hydrofluoric acid is preferably selected as a material forming the first protection film 40a.

The sidewall layer 14a is formed on the channel 20 side (+Z side) of the first protection film 40a.

In the present specification, a fluid which flows through the channel may be a liquid, and may be a gas.

A groove 16 is formed on the sidewall layer 14a at a position corresponding to the channel 20. A material forming the sidewall layer 14a may be selected in the same manner as in the first protection film 40a. A material forming the sidewall layer 14a may be the same as or different from that of the first protection film 40a. Second wiring portions 31c and 31d which will be described later are formed on an upper surface 14c of the sidewall layer 14a and a sidewall of the groove 16. The second protection film 41a is formed on the upper surface 14c of the sidewall layer 14a so as to cover the second wiring portions 31c and 31d.

The second protection film 41a is made of an insulating material in the same manner as the first protection film 40a. A material forming the second protection film 41a may be selected in the same manner as in the first protection film 40a. A material forming the second protection film 41a may be the same as or different from that of the first protection film 40a.

The second laminated substrate 15b is formed of a support substrate 13b, a first protection film 40b, a sidewall layer 14b, and a second protection film 41b which are laminated in this order.

A groove 19, and through holes 24, 25 and 26 illustrated in Figs. 1 and 2 are formed on a surface of the second laminated substrate 15b on the first laminated substrate 15a side (-Z side). The groove 19 communicates with the through holes 24, 25 and 26.

The support substrate 13b is the same as the support substrate 13a of the first laminated substrate 15a as illustrated in Fig. 3. The first protection film 40b is the same as the first protection film 40a of the first laminated substrate 15a. The sidewall layer 14b is the same as the sidewall layer 14a of the first laminated substrate 15a. The second protection film 41b is the same as the second protection film 41a of the first laminated substrate 15a.

The first laminated substrate 15a and the second laminated substrate 15b are bonded to each other so that the groove 18 and the groove 19 formed on the respective surfaces of the laminated substrates face each other. The channel 20 is formed of the groove 18 and the groove 19.

The channel 20 is a passage through which a fluid, that is, a chemically synthesized reagent, or a product which is generated through chemical synthesis flows. A sectional shape of the channel 20 is not particularly limited, and may be a circular shape, and may be a rectangular shape. In the present embodiment, a sectional shape of the channel 20 is, for example, a rectangular shape. The channel 20 includes, as illustrated in Fig. 1, a first channel portion (channel) 21, a second channel portion (channel) 22, and the synthesis channel portion (channel) 23.

The first channel portion 21 is a channel through which a reagent (fluid) D1a flows. An end of the first channel portion 21 on the upstream side communicates with the through hole 24 formed in the second laminated substrate 15b as illustrated in Fig. 2. A reagent injection device 50 is provided at a position where the through hole 24 is open on an upper surface 12a of the substrate 12. The reagent injection device 50 is a device injecting the reagent D1a. In other words, the reagent D1a is injected into the first channel portion 21 from the reagent injection device 50 via the through hole 24.

As illustrated in Fig. 1, an end of the first channel portion 21 on the downstream side is connected to the synthesis channel portion 23.

The second channel portion 22 is a channel through which a reagent (fluid) D1b flows. An end of the second channel portion 22 on the upstream side communicates with the through hole 25 formed in the second laminated substrate 15b. A reagent injection device 51 is provided at a position where the through hole 25 is open on the upper surface 12a of the substrate 12. The reagent injection device 51 is a device injecting the reagent D1b. In other words, the reagent D1b is injected into the second channel portion 22 from the reagent injection device 51 via the through hole 25.

An end of the second channel portion 22 on the downstream side is connected to the synthesis channel portion 23.

The reagent injection devices 50 and 51 are not particularly limited, and any well-known injection device may be used.

The synthesis channel portion 23 is a channel into which the reagent D1a and the reagent D1b flow from the first channel portion 21 and the second channel portion 22. In the synthesis channel portion 23, the reagent D1a and the reagent D1b are chemically synthesized with each other so that a product (fluid) D1c is generated. The synthesis channel portion 23 is formed to extend in the length direction (X axis direction) of the substrate 12 in the present embodiment.

An end of the synthesis channel portion 23 on the downstream side communicates with the through hole 26 as illustrated in Fig. 2. A product extraction device 52 is provided at a position where the through hole 26 is open on the upper surface 12a of the substrate 12. The product extraction device 52 is a device which extracts the product D1c generated in the synthesis channel portion 23 to the outside of the substrate 12. In other words, the product D1c is extracted to the outside of the substrate 12 from the synthesis channel portion 23 via the through hole 26 by the product extraction device 52.

A length (a length in the X axis direction in the figures) of the synthesis channel portion 23 may be set according to chemical synthesis reaction between the reagent D1a and the reagent D1b. In other words, as time required in the chemical synthesis reaction between the reagent D1a and the reagent D1b increases, the length of the synthesis channel portion 23 is set to become larger, and, as time required in the chemical synthesis reaction between the reagent D1a and the reagent D1b decreases, the length of the synthesis channel portion 23 is set to become smaller.

As illustrated in Figs. 4 and 5, a plurality of ridges (projections) 42a and 42b and a plurality of ridges (projections) 43 are formed on an inner wall surface 23a of the synthesis channel portion 23.

The ridges 42a are formed on a lower surface (a surface on the -Z side) of the inner wall surface 23a of the synthesis channel portion 23. The ridges 42a extend in the entire width direction (Y axis direction) of the lower surface of the synthesis channel portion 23, and are arranged in the flow direction (X axis direction).

The ridges 42b are formed on a top surface (a surface on the +Z side) of the inner wall surface 23a of the synthesis channel portion 23. The ridges 42b extend in the entire width direction (Y axis direction) of the top surface of the synthesis channel portion 23, and are arranged in the flow direction (X axis direction) so as to face the ridges 42a.

As illustrated in Fig. 5, the ridges 43 are formed on one side surface (a surface on the +Y side) of the inner wall surface 23a of the synthesis channel portion 23. The ridges 43 extend in the entire height direction (Z axis direction) of one side surface of the inner wall surface 23a, and are arranged in the flow direction (X axis direction). Ends of the ridges 43 on a lower side (-Z side) are connected to ends of the ridges 42a on one side (+Y side). Ends of the ridges 43 on an upper side (+Z side) are connected to ends of the ridges 42b on one side (+Y side) although not illustrated.

Although not illustrated, the same ridges as the ridges 43 are formed to face the ridges 43 on a side surface (a surface on the -Y side) of the inner wall surface 23a on the other side. Ends of the ridges on a lower side (-Z side) are connected to ends of the ridges 42a on the other side (-Y side). Ends of the ridges on an upper side (+Z side) are connected to ends of the ridges 42b on the other side (-Y side).

In other words, the respective ridges are connected to each other, and thus a plurality of rectangular annular projections which project from the inner wall surface 23a in a sectional view are formed to be arranged on the inner wall surface 23a of the synthesis channel portion 23 in the flow direction (X axis direction).

### (Wiring portion group)

The wiring portion group 30 is an element for detecting leakage of a fluid which passes through the channel 20. The wiring portion group 30 is formed of a plurality of wiring portions 31. In the present embodiment, the wiring portion group 30 is embedded around the synthesis channel portion 23 in the substrate 12 as illustrated in Figs. 1, 2 and 3. In other words, in the present embodiment, the wiring portion group 30 detects leakage of the reagents D1a and D1b or the product D1c in the synthesis channel portion 23.

The number of wiring portions 31 included in the wiring portion group 30 is not particularly limited. The plurality of wiring portions 31 are arranged in the flow direction (X axis direction) of the synthesis channel portion 23. In the present embodiment, a length direction of the wiring portions 31 is a direction (Y axis direction) which is orthogonal to the flow direction of the synthesis channel portion 23.

As illustrated in Fig. 3, the wiring portions 31 are provided to surround the periphery of the synthesis channel portion 23 (channel 20) in a sectional view (in a YZ-plane view). In the present embodiment, the wiring portions 31 are provided at positions corresponding to the respective ridges 42a, 42b and 43, as illustrated in Figs. 4 and 5. As illustrated in Fig. 3, the wiring portions 31 include first wiring portions (wiring portions) 31a and 31b, second wiring portions (wiring portions) 31c, 31d, 31e and 31f, penetration wiring portions 33a and 33b, and connection terminal portions 32a and 32b.

The first wiring portion 31a is a wiring portion provided on the upper surface 13c of the support substrate 13a in the first laminated substrate 15a as described above. A shape of the first wiring portion 31a is a strip shape extending in the width direction (Y axis direction) of the substrate 12. The first wiring portion 31a is embedded on the lower side (-Z side) of the synthesis channel portion 23 in the substrate 12. In the present embodiment, the first wiring portion 31a is provided at positions corresponding to the ridges 42a.

A material forming the first wiring portion 31a is not particularly limited as long as the material has a property in which an electric resistance value thereof changes due to contact with fluids flowing through the synthesis channel portion 23, that is, the reagents D1a and D1b or the product D1c in the present embodiment. A material forming the first wiring portion 31a may be, for example, aluminum (A1), copper (Cu), molybdenum (Mo), tantalum (Ta), tungsten (W), and alloys thereof, or metal such as indium tin oxide (ITO).

Here, a case where an electric resistance value of each of the wiring portions 31 changes due to contact with a fluid is, for example, a case where the wiring portions 31 are corroded by the fluid or a case where a formed material changes in quality due to chemical reaction.

The first wiring portion 31b is a wiring portion provided on a lower surface 13d of the support substrate 13b on the channel 20 side (-Z side) in the second laminated substrate 15b. In the same manner as the first wiring portion 31a, the first wiring portion 31b has a strip shape extending in the width direction (Y axis direction) of the substrate 12, and is provided to overlap the first wiring portion 31a in a plan view (in an XY-plane view). The first wiring portion 31b is embedded on the upper side (+Z side) of the synthesis channel portion 23 in the substrate 12. In the present embodiment, the first wiring portion 31b is provided at positions corresponding to the ridges 42b.

A material forming the first wiring portion 31b may be selected in the same manner as in the first wiring portion 31a.

The second wiring portions 31c and 31d are formed on the upper surface 14c of the sidewall layer 14a and the sidewall of the groove 16 as described above. In the same manner as the first wiring portion 31a, the second wiring portions 31c and 31d are formed in a strip shape, and are provided to overlap the first wiring portion 31a in a plan view (in an XY-plane view). The second wiring portion 31c is embedded on one side (+Y side) of the synthesis channel portion 23 in the substrate 12. The second wiring portion 31d embedded on the other side (-Y side) of the synthesis channel portion 23 in the substrate 12.

A material forming the second wiring portions 31c and 31d may be selected in the same manner as in the first wiring portion 31a.

The second wiring portions 31e and 31f are formed on a lower surface 14d of the sidewall layer 14b and a sidewall of the groove 17. In the same manner as the first wiring portion 31b, the second wiring portions 31e and 31f are formed in a strip shape, and are provided to overlap the first wiring portion 31a in a plan view (in an XY-plane view). The second wiring portion 31e is embedded on one side (+Y side) of the synthesis channel portion 23 in the substrate 12. The second wiring portion 31f embedded on the other side (-Y side) of the synthesis channel portion 23 in the substrate 12.

A material forming the second wiring portions 31e and 31f may be selected in the same manner as in the first wiring portion 31a.

In the present embodiment, the second wiring portions 31c and 31e are provided at positions corresponding to the ridges 43 illustrated in Fig. 5, and the second wiring portions 31d and 31f are provided at positions corresponding to the ridges (not illustrated) facing the ridges 43.

Here, in the present specification, "being provided at corresponding to ridges (projections)" indicates being provided at positions overlapping the ridges in a plan view of a surface on which the ridges are formed. Similarly, in the present specification, "being provided at corresponding to recesses" indicates being provided at positions overlapping the recesses in a plan view of a surface on which the recesses are formed.

As illustrated in Fig. 3, the penetration wiring portion 33a is provided to penetrate from the upper surface 12a of the substrate 12 to the first wiring portion 31a. The penetration wiring portion 33a electrically connects the connection terminal portion 32a formed on the upper surface 12a of the substrate 12, ends of the first wiring portions 31a and 31b on one side (+Y side), and ends of the second wiring portions 31c and 31e on one side (+Y side) to each other.

The connection terminal portion 32a is a terminal connected to a wiring of the detector 60.

Materials forming the penetration wiring portion 33a and the connection terminal portion 32a may be selected in the same manner as in the first wiring portion 31a.

The penetration wiring portion 33b is provided to penetrate from the upper surface 12a of the substrate 12 to the first wiring portion 31a in the same manner as the penetration wiring portion 33a. The penetration wiring portion 33b electrically connects the connection terminal portion 32b formed on the upper surface 12a of the substrate 12, ends of the first wiring portions 31a and 31b on the other side (-Y side), and ends of the second wiring portions 31d and 31f on the other side (-Y side) to each other.

The connection terminal portion 32b is a terminal connected to a wiring of the detector 60 in the same manner as the connection terminal portion 32a.

Materials forming the penetration wiring portion 33b and the connection terminal portion 32b may be selected in the same manner as in the first wiring portion 31a.

The first wiring portions 31a and 31b and the second wiring portions 31c to 31f are electrically connected to each other via the penetration wiring portions 33a and 33b.

As illustrated in Fig. 1, the detector 60 detects each of electric resistance values of the wiring portions 31, and thus detects leakage of fluids, that is, the reagents D1a and D1b or the product D1c out of the synthesis channel portion 23 in the present embodiment. In the present embodiment, the detector 60 is provided separately from the synthesis section 11. The detector 60 is connected to the wiring portions 31 via the connection terminal portions 32a and 32b formed on the upper surface 12a of the substrate 12. In Fig. 1, a wiring connecting the detector 60 to the connection terminal portions 32a is not illustrated.

The detector 60 applies a voltage between the connection terminal portions 32a and the connection terminal portions 32b of the wiring portions 31 and thus detects an electric resistance value of each of the wiring portions 31 from values of currents flowing through the wiring portions 31. In a case where the detected electric resistance value changes by a predetermined value or greater relative to a reference electric resistance value, the detector 60 determines that a fluid leaks out of the synthesis channel portion 23 (channel 20).

The reference electric resistance value may be stored in the detector 60, and may be acquired by providing separate wiring portions which are the same as the wiring portions 31 in the substrate 12 and by appropriately detecting electric resistance values of the wiring portions. In a case where the separate wiring portions are provided in the substrate 12, the wiring portions are preferably provided at a location which hardly contact with a fluid when the fluid leaks. If the reference electric resistance value is acquired from the separate wiring portions provided in the substrate 12, in a case where electric resistance values of the wiring portions 31 change due to factors other than contact with a fluid, for example, deterioration over time, the detector 60 can be prevented from wrongly determining leakage of a fluid in that case.

### [Method of Manufacturing Chemical Synthesis Device]

The chemical synthesis device 10 of the present embodiment is manufactured by connecting the synthesis section 11 to the detector 60. Hereinafter, a method of forming the synthesis section 11 of the present embodiment will be described.

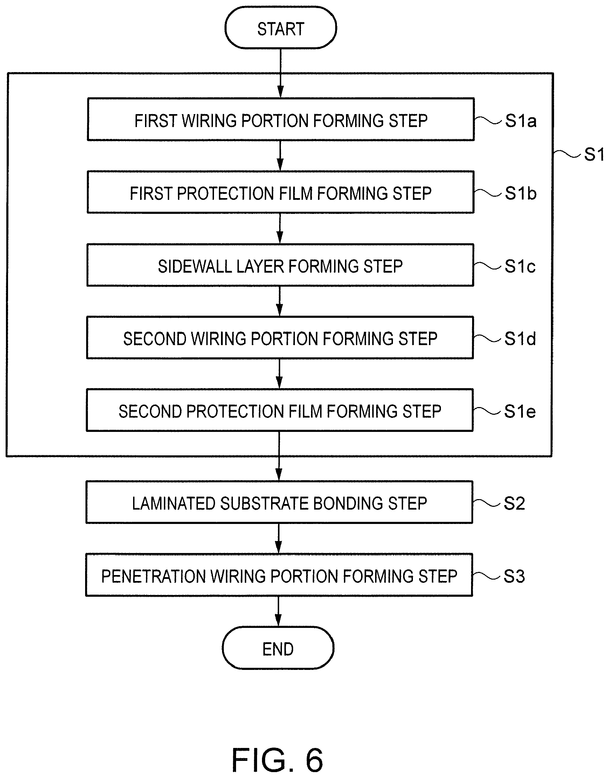

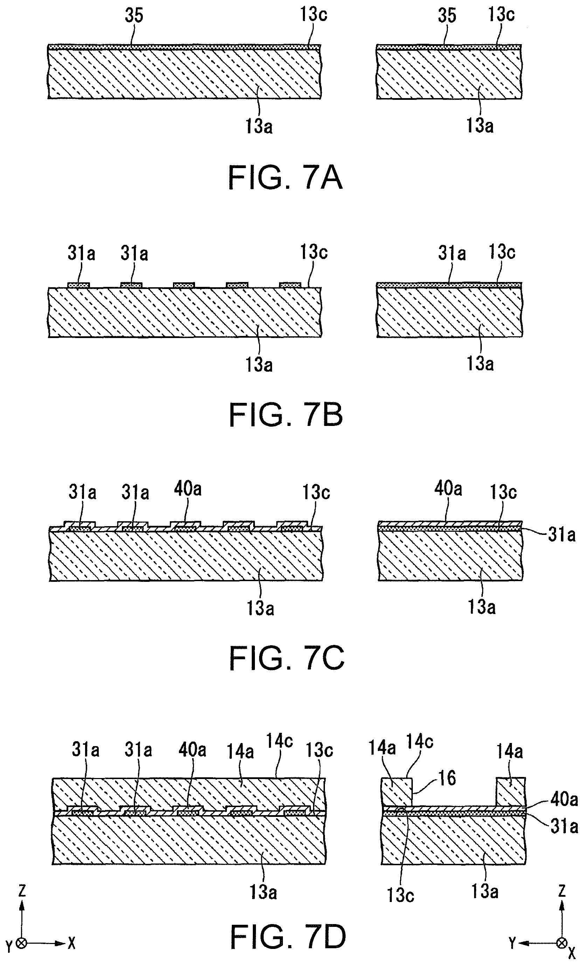

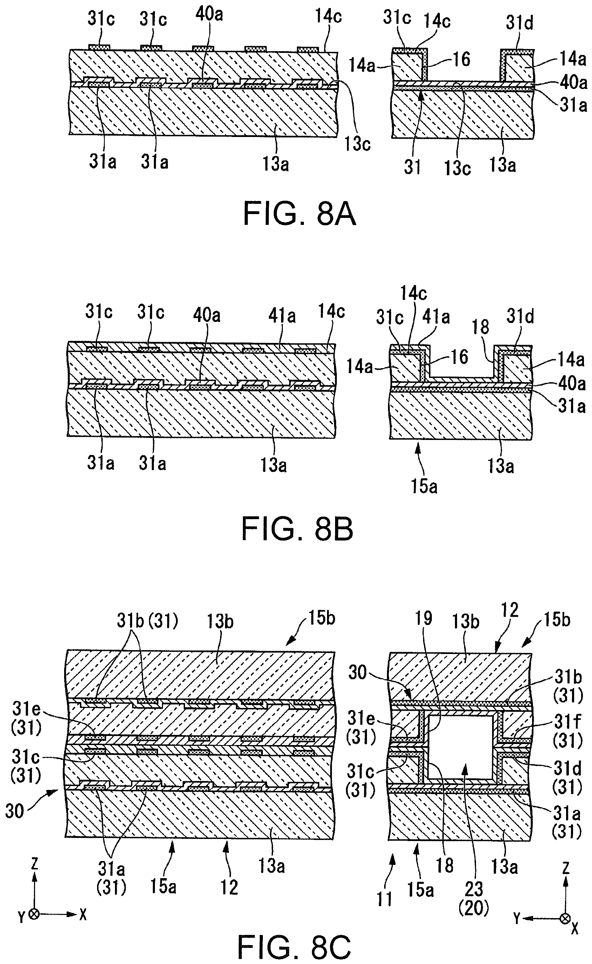

Fig. 6 is a flowchart illustrating procedures of forming the synthesis section 11 of the present embodiment. Figs. 7A to 7D and Figs. 8A to 8C are sectional views illustrating procedures of forming the synthesis section 11 of the present embodiment. In Figs. 7A to 7D and Figs. 8A to 8C, ZX sections and YZ sections are illustrated in an arranged manner.

The method of forming the synthesis section 11 of the present embodiment includes a laminated substrate forming step S1, a laminated substrate bonding step S2, and a penetration wiring portion forming step S3 as illustrated in Fig. 6.

The laminated substrate forming step S1 is a step in which one of the first laminated substrate 15a and the second laminated substrate 15b is formed. In the present embodiment, the first laminated substrate 15a and the second laminated substrate 15b have substantially the same configuration, and, thus, in the following description, the laminated substrate forming step S1 will be described by exemplifying a case of forming the first laminated substrate 15a.

The laminated substrate forming step S1 includes a first wiring portion forming step S1a, a first protection film forming step S1b, a sidewall layer forming step S1c, a second wiring portion forming step S1d, and a second protection film forming step S1e.

The first wiring portion forming step S1a is a step in which the first wiring portion 31a is formed on the upper surface 13c of the support substrate 13a as illustrated in Figs. 7A and 7B. In the present embodiment, a description will be made of a case where a material forming the wiring portions 31 is, for example, metal.

First, as illustrated in Fig. 7A, a metal film 35 made of the material forming the first wiring portion 31a is formed on the upper surface 13c of the support substrate 13a. A method of forming the metal film 35 is not particularly limited, and, for example, a sputtering method may be used.

Next, as illustrated in Fig. 7B, the metal film 35 is etched so that locations other than a location which will be the first wiring portion 31a are removed. An etching method is not particularly limited, and dry etching or wet etching may be used. Through this step, the first wiring portion 31a is formed on the upper surface 13c of the support substrate 13a.

Next, the first protection film forming step S1b is a step in which the first protection film 40a is formed on the upper surface 13c of the support substrate 13a as illustrated in Fig. 7C.

A method of forming the first protection film 40a is not particularly limited, and, for example, a chemical vapor deposition (CVD) method or a coating method may be selected.

Here, since the first wiring portion 31a is formed on the upper surface 13c of the support substrate 13a, ridges are formed on the upper surface of the first protection film 40a so as to correspond to the location where the first wiring portion 31a is formed.

Next, the sidewall layer forming step S1c is a step in which the sidewall layer 14a provided with the groove 16 is formed on the first protection film 40a as illustrated in Fig. 7D.

A method of forming the sidewall layer 14a is not particularly limited, and there may be a method in which a layer made of a forming material is formed by using the same method as in the first protection film 40a, and then the groove 16 is formed through patterning so that the sidewall layer is formed, and a method in which a forming material is coated on locations other than a location which will be the groove 16 according to a screen printing method so that the sidewall layer is formed. Consequently, the sidewall layer 14a is formed.

Next, as illustrated in Fig. 8A, the second wiring portion forming step Sld is a step in which the second wiring portions 31c and 31d are formed on the upper surface 14c of the sidewall layer 14a and the sidewall of the groove 16 formed in the sidewall layer 14a.

A method of forming the second wiring portions 31c and 31d is not particularly limited, and, for example, the same forming method as in the first wiring portion 31a may be selected. Through this step, the second wiring portions 31c and 31d are formed.

Next, the second protection film forming step S1e is a step in which the second protection film 41a is formed on the sidewall layer 14a so as to cover the second wiring portions 31c and 31d as illustrated in Fig. 8B.

A method of forming the second protection film 41a is not particularly limited, and, for example, the same forming method as in the first protection film 40a may be selected. Through this step, the second protection film 41a is formed. The second protection film 41a covers inner walls of the groove 16, and thus the groove 18 is formed.

The above-described first wiring portion forming step S1a to the second protection film forming step S1e are performed, and thus the laminated substrate forming step S1 is completed so that the first laminated substrate 15a is formed.

The second laminated substrate 15b is formed by forming the through holes 24, 25 and 26 in addition to the above-described laminated substrate forming step S1. A method of forming the through holes 24, 25 and 26 is not particularly limited.

Next, the laminated substrate bonding step S2 is a step in which the first laminated substrate 15a and the second laminated substrate 15b are bonded to each other as illustrated in Fig. 8C.

The first laminated substrate 15a and the second laminated substrate 15b are bonded to each other so that the groove 18 faces the groove 19. A bonding method is not particularly limited, and, for example, a method of bonding the substrates by using an adhesive may be selected. Through this step, the first laminated substrate 15a and the second laminated substrate 15b are bonded to each other, and thus the substrate 12 provided with the channel 20 therein is formed.

Next, the penetration wiring portion forming step S3 is a step in which the penetration wiring portions 33a and 33b and the connection terminal portions 32a and 32b are formed.

A method of forming the penetration wiring portions 33a and 33b and the connection terminal portions 32a and 32b is not particularly limited. As a method of forming the penetration wiring portions 33a and 33b, a method may be selected in which through holes penetrating from the upper surface 12a to the first wiring portion 31a are formed in the substrate 12, and metal films are formed on inner walls of the through holes.

As a method of forming the connection terminal portions 32a and 32b, for example, the same forming method as in the first wiring portion 31a may be selected.

Through this step, the penetration wiring portions 33a and 33b and the connection terminal portions 32a and 32b are formed.

The above-described laminated substrate forming step S1 to the penetration wiring portion forming step S3 are performed, and thus the synthesis section 11 of the present embodiment is formed.

According to the present embodiment, the wiring portion group 30 is provided around the synthesis channel portion 23, and thus leakage of a fluid out of the synthesis channel portion 23 can be detected. Hereinafter, details thereof will be described.

In the chemical synthesis device, there are cases where an inner wall of a channel may be damaged due to corrosion caused by a fluid flowing through the channel, and thus the fluid may leak out of the channel. If the inner wall of the channel is further damaged, a hole penetrating to the outside of a substrate is formed in the inner wall of the channel, and thus there is a concern that the fluid in the channel may leak. If the fluid leaks out of the substrate, there is a concern over the occurrence of a problem that a quality of a generated compound changes because a ratio between chemically synthesized fluids changes, or a problem that a yield of a generated compound is reduced. Thus, there is a need for detecting leakage of a fluid out of a channel early.

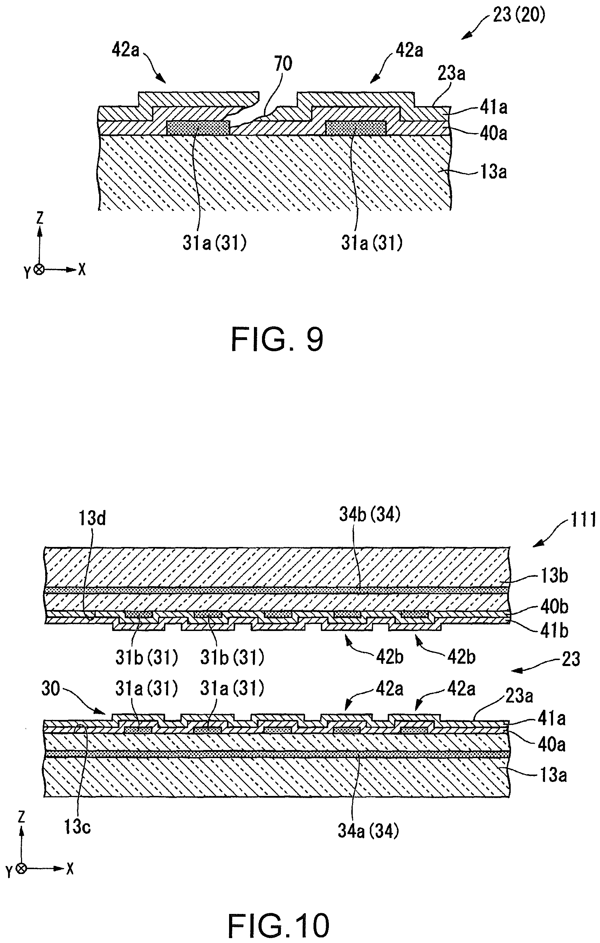

Fig. 9 is a sectional view illustrating a case where a part of the inner wall surface 23a of the synthesis channel portion 23 of the present embodiment is damaged. Fig. 9 illustrates a case where a damaged portion 70 penetrating from the inner wall surface 23a to the wiring portions 31 (first wiring portion 31a) is formed in the inner wall surface 23a of the synthesis channel portion 23.

According to the present embodiment, since the wiring portions 31 are provided, for example, as illustrated in Fig. 9, in a case where the inner wall surface 23a of the synthesis channel portion 23 is damaged, the reagents D1a and D1b or the product D1c comes into contact with the wiring portion 31 via the damaged portion 70. If the wiring portion 31 comes into contact with the reagents D1a and D1b or the product D1c, an electric resistance value thereof changes, and thus the detector 60 can detect the occurrence of leakage in the synthesis channel portion 23 by measuring the change in the electric resistance value of the wiring portion 31. Therefore, according to the present embodiment, it is possible to detect early that the inner wall surface 23a of the synthesis channel portion 23 is damaged, and a fluid leaks. As a result, it is possible to prevent the fluid from leaking out of the substrate 12 to the outside.

For example, in a case where a highly corrosive medicine such as a hydrofluoric acid is treated as a reagent, there is a concern that, when the reagent leaks out of the substrate 12, the surrounding environment may be damaged.

On the other hand, a fluorine compound which is generated by chemically synthesizing the hydrofluoric acid with other substances is widely used for pharmaceuticals and agricultural chemicals, and thus easy synthesis using a chemical synthesis device is desirable.

Therefore, the present embodiment is useful in a case where highly corrosive medicines are used as chemically synthesized reagents. The present embodiment is considerably useful in a case where, among highly corrosive medicines, a hydrofluoric acid is used as a chemically synthesized reagent.

According to the present embodiment, it is possible to reduce an amount of a wasted reagent due to leakage to the outside of the substrate 12 or a change in quality of a product, and thus to reduce cost.

According to the present embodiment, since the wiring portions 31 are provided to surround the periphery of the synthesis channel portion 23 in a sectional view, when a fluid leaks out of the synthesis channel portion 23, the fluid easily comes into contact with the wiring portions 31 and thus it becomes easier to detect the leakage of the fluid.

According to the present embodiment, the wiring portions 31 are provided in plurality, and are arranged in the flow direction (X axis direction) of the synthesis channel portion 23. Consequently, when the detector 60 detects leakage, the wiring portions 31 whose electric resistance values change are specified, and thus a location where the leakage occurs in the synthesis channel portion 23 can be recognized. Therefore, according to the present embodiment, when leakage occurs in the synthesis channel portion 23, it is possible to easily take a countermeasure such as recovering or replacing a location where the leakage occurs.

According to the present embodiment, the length direction of the wiring portions 31 is a direction (Y axis direction) which is orthogonal to the flow direction of the synthesis channel portion 23. Thus, it is possible to more accurately recognize a location where leakage occurs in the synthesis channel portion 23 than in a case where the length direction of the wiring portions 31 is tilted relative to the flow direction of the synthesis channel portion 23.

According to the present embodiment, since the ridges 42a, 42b and 43 are formed, it is possible to increase a surface area of the inner wall surface 23a of the synthesis channel portion 23. Consequently, for example, in a case where chemical reaction occurring in the synthesis channel portion 23 is endothermic reaction, it is possible to easily apply heat to a fluid flowing through the synthesis channel portion 23 by heating the synthesis channel portion 23. Thus, it is possible to promote chemical reaction in the synthesis channel portion 23.

According to the present embodiment, the first wiring portions 31a and 31b are provided to correspond to the positions where the ridges 42a and 42b are formed. Thus, for example, compared with a case where wiring portions are provided at positions corresponding to recesses formed on an inner wall surface of a channel, it is possible to simply manufacture the chemical synthesis device 10 since time and effort to form the recesses on the support substrate 13a can be saved.

In the present embodiment, the following configurations and manufacturing methods may be employed.

In the above description, the wiring portion group 30 is configured to be provided around only the synthesis channel portion 23, but is not limited thereto. In the present embodiment, the wiring portion group 30 may be provided around all of the first channel portion 21, the second channel portion 22, and the synthesis channel portion 23, and the wiring portion group 30 may be provided around one or two thereof.

In the above description, the wiring portion group 30 is configured to include a plurality of wiring portions 31, but is not limited thereto. In the present embodiment, for example, only a single wiring portion 31 may be provided around the channel 20.

In the present embodiment, the wiring portions 31 are configured to be provided to surround the periphery of the synthesis channel portion 23 (channel 20) in a sectional view, but are not limited thereto. In the present embodiment, arrangement of the wiring portions 31 is not particularly limited as long as the wiring portions 31 are provided at least at a part of the periphery of the synthesis channel portion 23 in a sectional view.

As an example, the wiring portions 31 may be configured to be provided on only the lower side (-Z side) of the synthesis channel portion 23. In this case, the synthesis section may be manufactured by performing the above-described first wiring portion forming step S1a to the sidewall forming step S1c (refer to Fig. 7D) and then bonding, for example, the same substrate as the support substrate 13a to the upper surface 14c of the sidewall layer 14a.

In the above description, the detector 60 is configured to determine an electric resistance value of each of the wiring portions 31 and determine whether or not leakage occurs, but is not limited thereto.

In the present embodiment, a circuit such as a bridge circuit may be formed by using two or more wiring portions 31, and the detector 60 may detect leakage. According to this configuration, for example, even in a case where a fluid such as ethanol or water which causes a small change in an electric resistance value when coming into contact with the wiring portions 31 is used as a reagent, the sensitivity of detection of a change in an electric resistance value can be improved, and thus leakage is easily detected. The two or more wiring portions 31 used in this configuration may be the wiring portions 31 adjacent to each other, and may be the wiring portions 31 with other wiring portions 31 therebetween.

In the present embodiment, each of the wiring portions 31 may function as a heating portion. In this case, for example, as a material forming the wiring portions 31, a material which is heated through conduction is used. Consequently, the voltages applied to the connection terminal portions 32a and 32b are adjusted by the detector 60 so that currents flowing through the wiring portions 31 are adjusted, and thus it is possible to control heating of the synthesis channel portion 23 with the wiring portions 31. According to the configuration, it is possible to improve temperature controllability of a fluid in the synthesis channel portion 23 compared with a batch type reactor of the related art. Therefore, in a case where chemical reaction occurring in the synthesis channel portion 23 is endothermic reaction, it is possible to improve a yield of the product D1c. All of the wiring portions 31 may function as heating portions, and some of the wiring portions 31 may function as heating portions.

A method of causing the wiring portions 31 to function as heating portions is not limited to heating through conduction, and, for example, there may be a method of heating all the wiring portions 31 by directly heating the connection terminal portions 32a and 32b exposed to the upper surface 12a of the substrate 12.

In the present embodiment, a heating portion may be provided separately from the wiring portions 31. In this case, a configuration of the heating portion is not particularly limited.

In the above description, the ridges 42a are configured to extend in the entire width direction (Y axis direction) of the synthesis channel portion 23, but are not limited thereto. In the present embodiment, the ridges 42a may be partially formed in the width direction (Y axis direction) of the synthesis channel portion 23. This is also the same for the ridges 42b and 43, and the ridges (not illustrated) facing the ridges 43.

In the present embodiment, the first wiring portions 31a and 31b and the second wiring portions 31c to 31f may not overlap each other in a plan view (in an XY-plane view).

In the present embodiment, the wiring portions 31 may not be provided at the positions corresponding to the ridges 42a, 42b and 43.

In the present embodiment, configurations of the penetration wiring portions 33a and 33b are not particularly limited as long as electrical connection can occur in the first wiring portions 31a and 31b and the second wiring portions 31c to 31f.

In the present embodiment, means for electrical connection of the first wiring portions 31a and 31b and the second wiring portions 31c to 31f is not limited to the penetration wiring portions 33a and 33b, and any means may be used.

In the present embodiment, an auxiliary wiring portion may be provided in addition to the wiring portion group 30. Fig. 10 is a partial enlarged sectional view illustrating another example of the synthesis section of the present embodiment.

As illustrated in Fig. 10, a synthesis section 111 is different from the above-described synthesis section 11 in that auxiliary wiring portions 34 are provided.

The auxiliary wiring portions 34 are provided at positions further separated from the synthesis channel portion 23 than the wiring portion group 30. The auxiliary wiring portions 34 include a first auxiliary wiring portion (auxiliary wiring portion) 34a provided in the support substrate 13a, a second auxiliary wiring portion (auxiliary wiring portion) 34b provided in the support substrate 13b, and side surface auxiliary wiring portions (not illustrated) provided in the sidewall layers 14a and 14b. Although not illustrated, the auxiliary wiring portions 34 are provided to surround the periphery of the synthesis channel portion 23 in a sectional view (in YZ-plane view) in the entire flow direction (X axis direction) of the synthesis channel portion 23.

According to this configuration, since the auxiliary wiring portions 34 are formed in the entire flow direction of the synthesis channel portion 23, even in a case where a fluid which has leaked out of the synthesis channel portion 23 does not come into contact with the wiring portion group 30 and reaches to an outward location of the wiring portion group 30, the fluid comes into contact with the auxiliary wiring portions 34, and thus it is possible to detect the leakage of the fluid out of the synthesis channel portion 23.

Configurations of the auxiliary wiring portions 34 are not particularly limited as long as the auxiliary wiring portions 34 are provided at locations further separated from the synthesis channel portion 23 than the wiring portion group 30, and may be partially formed in the flow direction of the synthesis channel portion 23, may be partially provided on the periphery of the synthesis channel portion 23 in a sectional view (in a YZ-plane view), and may be formed in the entire flow direction of the channel 20.

In the present embodiment, the support substrates 13a and 13b, the first protection films 40a and 40b, the sidewall layers 14a and 14b, and the second protection films 41a and 41b may be all made of an inorganic substance such as SiO₂, and a protection film with excellent corrosion resistance may be formed on surfaces of the second protection films 41a and 41b which will be an inner wall surface of the channel 20.

In the above-described method of forming the synthesis section 11, the substrate 12 is formed, and then the penetration wiring portions 33a and 33b are formed, but the invention is not limited thereto. In the present embodiment, there may be a method in which the penetration wiring portions 33a and 33b are formed by partially removing protection films and the like to be formed, in each step of the laminated substrate forming step S1.

### <Second Embodiment>

A second embodiment is different from the first embodiment in that wiring portions 231 are formed at positions corresponding to recesses 242a and 242b formed on an inner wall surface 223a of a synthesis channel portion 223.

In the following description, the same constituent elements as those in the above-described embodiment are given the same reference numerals as appropriate, and description thereof will be omitted in some cases.

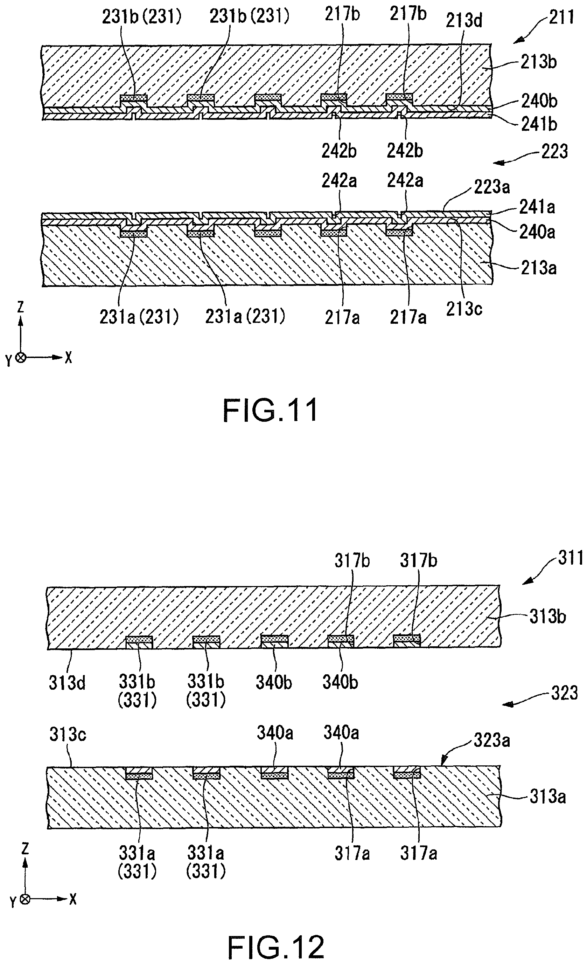

Fig. 11 is a partial enlarged sectional view illustrating a synthesis channel portion 223 of a synthesis section 211 of the present embodiment. As illustrated in Fig. 11, in the present embodiment, recesses 217a are formed on an upper surface 213c of a support substrate 213a. Recesses 217b are formed on a lower surface 213d of a support substrate 213b. Wiring portions 231a are formed on bottoms of the recesses 217a, and wiring portions 231b are formed on bottoms of the recesses 217b.

A first protection film 240a and a second protection film 241a are laminated in this order on the upper surface 213c of the support substrate 213a. A first protection film 240b and a second protection film 241b are laminated in this order on the lower surface 213d of the support substrate 213b.

The recesses 217a and 217b are formed on the support substrates 213a and 213b, and thus recesses 242a and 242b at which the first protection film 240a and the second protection film 241a are depressed are formed on an inner wall surface 223a of the synthesis channel portion 223. In other words, the wiring portions 231a and 231b are provided at positions corresponding to the recesses 242a and 242b.

Although not illustrated, a side surface of the synthesis channel portion 223 has the same configuration as described above.

According to the present embodiment, the wiring portions 231a and 231b are provided at positions corresponding to the recesses 242a and 242b. The recesses 242a and 242b are easily damaged due to corrosion earlier than other portions. Thus, when the synthesis channel portion 223 is damaged, a fluid which has leaked easily comes into contact with the wiring portions 231a and 231b provided to correspond to the recesses 242a and 242b. Therefore, according to the present embodiment, it is possible to detect leakage of a fluid out of the synthesis channel portion 223 earlier.

### <Third Embodiment>

A third embodiment is different from the first embodiment in that an inner wall surface 323a of a synthesis channel portion 323 is flat.

In the following description, the same constituent elements as those in the above-described embodiments are given the same reference numerals as appropriate, and description thereof will be omitted in some cases.

Fig. 12 is a partial enlarged sectional view illustrating the synthesis channel portion 323 of a synthesis section 311 of the present embodiment.

As illustrated in Fig. 12, in the present embodiment, recesses 317a are formed on an upper surface 313c of a support substrate 313a. Recesses 317b are formed on a lower surface 313d of a support substrate 313b. Wiring portions (wiring portions 331) 331a are formed on bottoms of the recesses 317a, and wiring portions (wiring portions 331) 331b are formed on bottoms of the recesses 317b.

A protection film 340a is formed on the wiring portions 331a so as to fill the recesses 317a. A protection film 340b is formed on the wiring portions 331b so as to fill the recesses 317b. A surface of the protection film 340a is connected to the upper surface 313c of the support substrate 313a without a step difference. A surface of the protection film 340b is connected to the lower surface 313d of the support substrate 313b without a step difference.

In the present embodiment, the inner wall surface 323a of the synthesis channel portion 323 is configured to include the upper surface 313c of the support substrate 313a, the lower surface 313d of the support substrate 313b, and the surfaces of the protection films 340a and 340b. In the present embodiment, the inner wall surface 323a of the synthesis channel portion 323 is formed to be flat.

As a material forming the protection films 340a and 340b, a material is used which has lower corrosion resistance to a fluid flowing through the synthesis channel portion 323 than that of a material forming the support substrates 313a and 313b. In other words, the portion located further toward the synthesis channel portion 323 than the wiring portions 331a and 331b in the substrate of the present embodiment has lower corrosion resistance to a fluid flowing through the synthesis channel portion 323 than that of other portions of the substrate of the present embodiment.

According to the present embodiment, since the inner wall surface 323a of the synthesis channel portion 323 is flat, it is hard to hinder a fluid from flowing through the synthesis channel portion 323 compared with a case where irregularities are formed on the inner wall surface. Therefore, according to the present embodiment, it is possible to stably perform chemical reaction in the synthesis channel portion 323, and, as a result, it is possible to stabilize a yield of a product.

When a reagent is injected into the channel, preferably, air in the channel is sucked by, for example, a vacuum pump so that the channel is brought into a vacuum state. In this case, according to the present embodiment, the inner wall surface 323a of the synthesis channel portion 323 is flat, and thus air is unlikely to remain in the synthesis channel portion 323.

According to the present embodiment, a material forming the protection films 340a and 340b has lower corrosion resistance to a fluid flowing through the synthesis channel portion 323 than that of a material forming the support substrates 313a and 313b. Thus, in the present embodiment, the synthesis channel portion 323 is easily damaged due to corrosion earlier in the portions of the protection films 340a and 340b than in the portions of the support substrates 313a and 313b. Therefore, according to the present embodiment, when the synthesis channel portion 323 is damaged due to corrosion, a fluid which has leaked easily comes into contact with the wiring portions 331a and 331b provided in the recesses 317a and 317b.

### <Fourth Embodiment>

A fourth embodiment is different from the first embodiment in that three kinds of reagents are synthesized with each other.

In the following description, the same constituent elements as those in the above-described embodiments are given the same reference numerals as appropriate, and description thereof will be omitted in some cases.

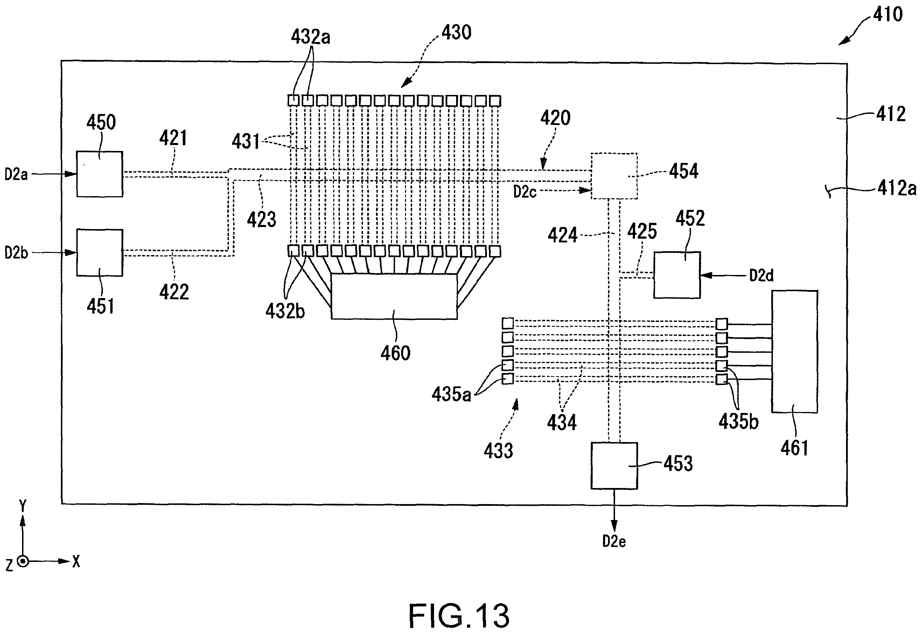

Fig. 13 is a plan view illustrating a chemical synthesis device 410 of the present embodiment.

As illustrated in Fig. 13, the chemical synthesis device 410 of the present embodiment includes a substrate 412, a wiring portion group 430, a wiring portion group 433, a first detector (detector) 460, and a second detector (detector) 461.

A channel 420 is formed inside the substrate 412.

The channel 420 includes a first channel portion (channel) 421, a second channel portion (channel) 422, a first synthesis channel portion (channel) 423, a liquid reserving portion 454, a second synthesis channel portion (channel) 424, and a third channel portion (channel) 425.

A reagent (fluid) D2a is injected into the first channel portion 421 from a reagent injection device 450. An end of the first channel portion 421 on the downstream side is connected to the first synthesis channel portion 423.

A reagent (fluid) D2b is injected into the second channel portion 422 from a reagent injection device 451. An end of the second channel portion 422 on the downstream side is connected to the first synthesis channel portion 423.

The reagent D2a and the reagent D2b flow into the first synthesis channel portion 423. In the first synthesis channel portion 423, the reagent D2a and the reagent D2b are chemically synthesized, and thus an intermediate product (fluid) D2c is generated. The wiring portion group 430 is embedded around the first synthesis channel portion 423. A configuration of the first synthesis channel portion 423 is the same as that of the synthesis channel portion 23 of the first embodiment. An end of the first synthesis channel portion 423 on the downstream side is connected to the liquid reserving portion 454.

The liquid reserving portion 454 is provided to cause the intermediate product D2c generated in the first synthesis channel portion 423 to stay therein. The liquid reserving portion 454 is connected to the second synthesis channel portion 424. For example, an adjustment mechanism such as an adjustment valve for adjusting an amount of the intermediate product D2c flowing through the second synthesis channel portion 424 from the liquid reserving portion 454 may be provided at a connection portion between the liquid reserving portion 454 and the second synthesis channel portion 424. Synthesis time for the intermediate product D2c or an amount of a fluid flowing through the second synthesis channel portion 424 may be adjusted by using a size or a depth of the liquid reserving portion 454.

The third channel portion 425 is connected to the second synthesis channel portion 424. A reagent (fluid) D2d is injected into the third channel portion 425 via a reagent injection device 452.

The intermediate product D2c and the reagent D2d flow into the second synthesis channel portion 424. The intermediate product D2c and the reagent D2d are chemically synthesized in the second synthesis channel portion 424, and thus a product (fluid) D2e is generated.

The wiring portion group 433 is embedded around the second synthesis channel portion 424. A configuration of the second synthesis channel portion 424 is the same as that of the synthesis channel portion 23 of the first embodiment. An end of the second synthesis channel portion 424 on the downstream side is connected to a product extraction device 453, and the product D2e is extracted from the product extraction device 453.

The wiring portion group 430 is embedded in the substrate 412. The wiring portion group 430 is formed of a plurality of wiring portions 431. The wiring portions 431 have the same configuration as that of the wiring portions 31 of the first embodiment, for example. The first detector 460 is connected to connection terminal portions 432a and connection terminal portions 432b of the wiring portions 431.

The wiring portion group 433 is embedded in the substrate 412. The wiring portion group 433 is formed of a plurality of wiring portions 434 in the present embodiment. The wiring portions 434 have the same configuration as that of the wiring portions 31 of the first embodiment, for example. The second detector 461 is connected to connection terminal portions 435a and connection terminal portions 435b of the wiring portions 434.

In the example illustrated in Fig. 13, the number of wiring portions 431 included in the wiring portion group 430 is larger than the number of wiring portions 434 included in the wiring portion group 433. For example, in a case where the reagent D2a is a reagent such as a hydrofluoric acid which is strongly desired to be prevented from leaking out of the substrate 412, the number of wiring portions 431 of the wiring portion group 430 provided around the first synthesis channel portion 423 which is a reaction channel thereof is increased, and thus it is possible to more reliably detect leakage.

The first detector 460 and the second detector 461 are provided on the upper surface 412a of the substrate 412 in the present embodiment. Configurations of the first detector 460 and the second detector 461 are the same as the configuration of the detector 60 of the first embodiment. The first detector 460 and the second detector 461 may be provided inside the substrate 412.

According to the present embodiment, in the same manner as in the first embodiment, it is possible to detect leakage of a fluid in the first synthesis channel portion 423 and the second synthesis channel portion 424.

According to the present embodiment, the first detector 460 and the second detector 461 are provided on the substrate 412, and thus the entire chemical synthesis device 410 can be miniaturized.

In the present embodiment, needless to say, configurations of the first synthesis channel portion 423 and the second synthesis channel portion 424 may be the same as the configuration of the synthesis channel portion in the second and third embodiments.

In the second to fourth embodiments, needless to say, the wiring portions may be embedded around the channel portions other than the synthesis channel portion.

### Reference Signs List

10 AND 410 CHEMICAL SYNTHESIS DEVICE, 12 AND 412 SUBSTRATE, 20 AND 420 CHANNEL, 21 AND 421 FIRST CHANNEL PORTION (CHANNEL), 22 AND 422 SECOND CHANNEL PORTION (CHANNEL), 23 SYNTHESIS CHANNEL PORTION (CHANNEL), 23a, 223a, AND 323a INNER WALL SURFACE, 31, 231, 231a, 231b, 331, 331a, 331b, 431, AND 434 WIRING PORTION, 31a AND 31b FIRST WIRING PORTION (WIRING PORTION), 31c, 31d, 31e, AND 31f SECOND WIRING PORTION (WIRING PORTION), 34 AUXILIARY WIRING PORTION, 34a FIRST AUXILIARY WIRING PORTION (AUXILIARY WIRING PORTION), 34b SECOND AUXILIARY WIRING PORTION (AUXILIARY WIRING PORTION), 42a, 42b, AND 43 RIDGE (PROJECTION), 60 DETECTOR, 242a AND 242b RECESS, 423 FIRST SYNTHESIS CHANNEL PORTION (CHANNEL), 424 SECOND SYNTHESIS CHANNEL PORTION (CHANNEL), 425 THIRD CHANNEL PORTION (CHANNEL), 460 FIRST DETECTOR (DETECTOR), 461 SECOND DETECTOR (DETECTOR), D1a, D1b, D2a, D2b, AND D2d REAGENT (FLUID), D1c AND D2e PRODUCT (FLUID), D2c INTERMEDIATE PRODUCT (FLUID)

## Claims

1. A chemical synthesis device comprising:
a substrate in which a channel for chemically synthesizing a plurality of fluids with each other is formed; and
a wiring portion that is embedded in the substrate,
wherein an electric resistance value of the wiring portion changes due to the wiring portion coming into contact with the fluids.

2. The chemical synthesis device according to claim 1,
wherein the wiring portion is provided to surround the periphery of the channel in a sectional view.

3. The chemical synthesis device according to claim 1 or 2,
wherein the wiring portion is provided in plurality,
wherein the plurality of wiring portions are arranged in a flow direction of the channel, and
wherein a length direction of each of the wiring portions intersects the flow direction of the channel.

4. The chemical synthesis device according to claim 3,
wherein the length direction of the wiring portion is orthogonal to the flow direction of the channel.

5. The chemical synthesis device according to any one of claims 1 to 4,
wherein a projection is formed on an inner wall surface of the channel.

6. The chemical synthesis device according to claim 5,
wherein the wiring portion is provided at a position corresponding to the projection.

7. The chemical synthesis device according to any one of claims 1 to 5,
wherein a recess is formed on an inner wall surface of the channel, and
wherein the wiring portion is provided at a position corresponding to the recess.

8. The chemical synthesis device according to any one of claims 1 to 7, further comprising:
a heating portion that heats the channel.

9. The chemical synthesis device according to claim 8,
wherein the wiring portion functions as the heating portion.

10. The chemical synthesis device according to claim 9,
wherein the wiring portion is heated through conduction.

11. The chemical synthesis device according to any one of claims 1 to 10, further comprising:
an auxiliary wiring portion whose electric resistance value changes due to contact with the fluids,
wherein the auxiliary wiring portion is embedded at a position further separated from the channel than a position where the wiring portion is provided.

12. The chemical synthesis device according to claim 11,
wherein the auxiliary wiring portion is provided to surround the periphery of the channel in a sectional view in the entire flow direction of the channel.

13. The chemical synthesis device according to any one of claims 1 to 12,
wherein a portion located further toward the channel side than the wiring portion in the substrate has lower corrosion resistance to the fluids than other portions in the substrate.

14. The chemical synthesis device according to any one of claims 1 to 13, further comprising:
a detector that detects a change in an electric resistance value of the wiring portion.

15. The chemical synthesis device according to claim 14,
wherein the detector is provided on the substrate.

16. The chemical synthesis device according to claim 14 or 15,
wherein the wiring portion is provided in plurality, and
wherein the detector detects a change in an electric resistance value of the wiring portion by comparing electric resistance values of at least two wiring portions with each other.

17. A method of manufacturing a chemical synthesis device including a substrate in which a channel for chemically synthesizing a plurality of fluids with each other is formed, the method comprising:
a step of forming a wiring portion which is embedded in the substrate and whose electric resistance value changes due to contact with the fluids.
